Europäisches Patentamt

European Patent Office

Office européen des brevets

(19)

(11) Publication number : **0 347 245 B1**

(12)

# EUROPEAN PATENT SPECIFICATION

(45) Date of publication of patent specification :
**12.04.95 Bulletin 95/15**

(51) Int. Cl.⁶ : **G03F 7/30**

(21) Application number : **89306131.7**

(22) Date of filing : **16.06.89**

(54) Method for development processing of presensitized plates.

(30) Priority : **17.06.88 JP 149617/88**

(43) Date of publication of application :
**20.12.89 Bulletin 89/51**

(45) Publication of the grant of the patent :
**12.04.95 Bulletin 95/15**

(84) Designated Contracting States :
**DE GB**

(56) References cited :
**EP-A- 0 050 818
EP-A- 0 080 659
DE-A- 3 007 401
DE-C- 3 204 912
US-A- 4 119 991
PATENT ABSTRACTS OF JAPAN vol. 11, no.
274 (P-612)(2721) 5 September 1987 ; &
JP-A-62 73 271**

(73) Proprietor : **FUJI PHOTO FILM CO., LTD.
No. 210, Nakanuma
Minami-Ashigara-shi
Kanagawa-ken (JP)**

(72) Inventor : **Kunichika, Kenji c/o FUJI PHOTO
FILM CO., LTD.
4000, Kawashiri
Yoshida-cho
Haibara-gun Shizuoka-ken (JP)**
Inventor : **Ohba, Hisao c/o FUJI PHOTO FILM
CO., LTD.
4000, Kawashiri
Yoshida-cho
Haibara-gun Shizuoka-ken (JP)**
Inventor : **Nishioka, Akira c/o FUJI PHOTO
FILM CO., LTD.
4000, Kawashiri
Yoshida-cho
Haibara-gun Shizuoka-ken (JP)**
Inventor : **Matsumoto, Hiroshi c/o FUJI PHOTO
FILM CO., LTD.
4000, Kawashiri
Yoshida-cho
Haibara-gun Shizuoka-ken (JP)**
Inventor : **Akiyama, Keiji c/o FUJI PHOTO FILM
CO., LTD.
4000, Kawashiri
Yoshida-cho
Haibara-gun Shizuoka-ken (JP)**

(74) Representative : **Blake, John Henry Francis et
al
BROOKES AND MARTIN
High Holborn House
52/54 High Holborn
London WC1V 6SE (GB)**

## Description

## BACKGROUND OF THE INVENTION

The present invention relates to a method for development processing a presensitized plate for use in making lightographic printing plates and more specifically to an improved method for development processing such presensitized plates which makes it possible to constantly perform stable development processing thereof.

When a large number of presensitized plates for use in making lithographic printing plates (hereinafter referred to as "PS plates") are processed after exposure to light, an automatic developing machine is generally utilized and it is one of the leading mainstreams in this field that alkaline developers composed of water as a main solvent are used as a developer for such development processing from the viewpoint of their safety and smell.

When exposed PS plates are processed with an automatic developing machine, it is general to spray a developer on the surface of a PS plate while horizontally conveying the PS plates and then to rub the surface with, for instance, a rotatable brush which is composed of a roll and nylon fibers implanted thereto to remove or completely dissolve unnecessary portions of the light-sensitive layer of the PS plate. In such processings, alkaline developers, in particular, developers containing an alkali metal silicate and having a pH of not less than 12 absorb carbon dioxide in the air and thus cause deterioration of their developing properties. Therefore, such a developer cannot remove unnecessary portions of the light-sensitive layer sufficiently from non-image areas of the PS plate and this accompanies troublesome operations such as exchange of developer.

To eliminate such disadvantages, Japanese Patent Un-examined Publication (hereunder referred to as "J.P. KOKAI") Nos. Sho 54-62004 (U.S. Patent 4,259,434), Sho 56-12645 (G.B. 2046931A) and Sho 58-95349 (U.S. Patent 4,537,496) disclose methods in which a replenisher for developer is supplemented to regenerate a deteriorated developer and to thus reduce the frequency of exchange of the developer. Such a method for supplementing a replenisher permits the reduction in the frequency of developer exchange, but cannot prevent the deterioration of the developer due to absorption of carbon dioxide in the air. Moreover, silicates adhere to the surface of internal walls of a developing bath and/or a top cover thereof due to splashing of the developer by a brush or they suspend in the developer. These phenomena possibly lead to clogging of a spray nozzle and cause problems concerning quality of products obtained after the development processing such as adhesion of extraneous matters. They in turn make washing operations difficult. Such problems become more severer, in particular when the temperature of a developer is raised to not less than 28 ° C to reduce time required for development processing.

As a means for eliminating such complicatedness of the development processing in which developers for PS plates containing alkali metal silicates are used, J.P. KOKAI Nos. Sho 55-32044 and Sho 61-243455 or U.S. Patent No. 4,222,656 disclose methods comprising supplying a substantially fresh developer to a PS plate to perform development processing. Since a substantially fresh developer is used for every PS plates in these methods, the developer is not influenced by carbon dioxide in the air and the activity of the developer solution is very stable. However, to perform uniform development over the whole surface of an exposed PS plate, it is necessary to provide a liquid film of a developer having a uniform thickness on the surface of the PS plate and to use a coating apparatus having high precision and complicated constructions. Moreover, if an automatic developing machine is stopped at night or during holidays, silicates contained in the developer used are liable to be separated out on portions for coating and a brush of the coating apparatus and thus problems concerning, for instance, stability of the processing and formation of defects of PS plates arise. In addition, this method requires the use of a large amount of developer compared with the conventional development processing in which a replenisher therefor is supplemented and hence the running cost of the method is also increased, because of curling of PS plate and folding thereof at its front edge.

## SUMMARY OF THE INVENTION

After extensive studies relating to the disadvantages revealed above in prior art procedures, we have achieved the method of the present invention. which is especially suitable for developing machines intended for automatic operation.

The present invention provides a method for development processing a presensitised plate for use in making a lithographic printing plate comprising the steps of:

(i) imagewise exposing to light a presensitised plate comprising an aluminum plate having an anodised layer of 0.5 to 6 g/m$^2$ and a lithographically suitable photosensitive layer on the anodised layer; and

(ii) development processing the exposed presensitised plate utilising a conveying type automatic developing machine while conveying and dipping the plate in an alkaline developer charged in a tank, and while appropriately supplying a replenisher to the tank, the machine being provided with a plate for reducing contact between air and a surface of the alkaline developer in the tank so as to remove non-image areas of the photosensitive layer and the plate providing a rate of shielding of the developer surface for preventing the contact between the developer and air which is not less than 60% of the whole developer-air interface; wherein the developer and the replenisher are aqueous solutions of an alkali metal silicate, and wherein the ratio $[SiO_2]/[M_2O]$ of the replenisher ranges from 0.6 to 1.5, wherein $[SiO_2]$ is the molar concentration of $SiO_2$ and $[M_2O]$ is the molar concentration of an alkali metal oxide $M_2O$.

## BRIEF DESCRIPTION OF THE DRAWINGS

Fig. 1 is a diagram illustrating one embodiment of conveying type automatic developing machine provided with a part for dipping and developing PS plates, used in the method of this invention; and

Fig. 2 is a diagram showing one embodiment of a conventional spraying type automatic developing machine.

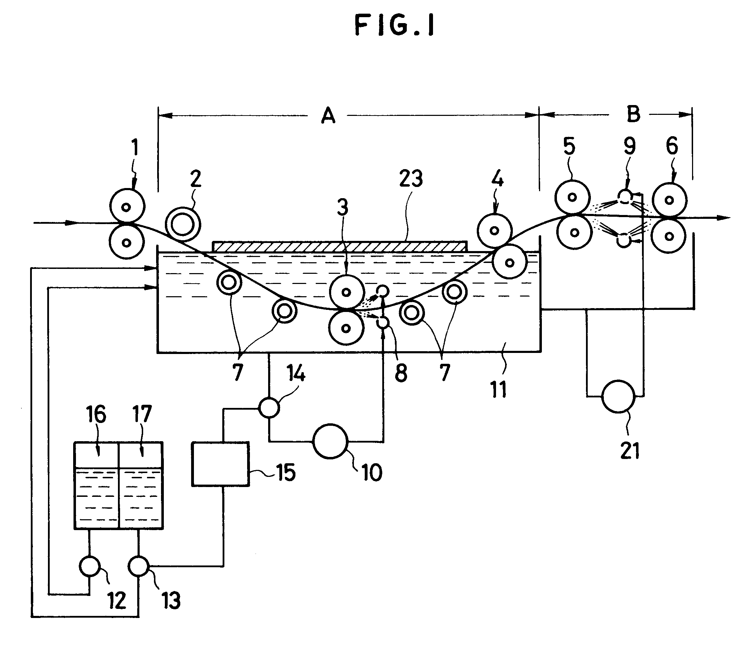

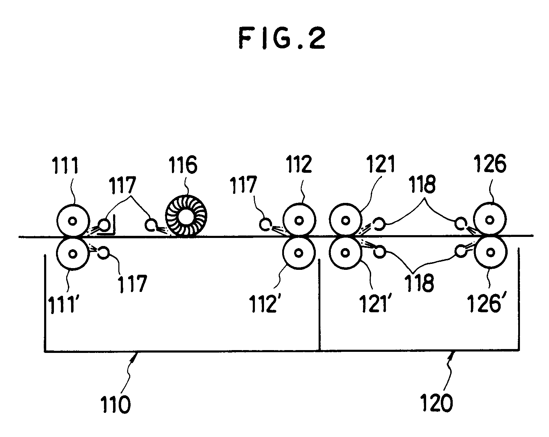

In Figs. 1 and 2, reference numberals have the following meanings. 1, 3, 4, 5, 6 ... conveyer roller, 2, 7 ... guide roller, 8, 9 ... spray, 10, 21 ... circulation pump, 11 ... developer, 12, 13 ... supplementation pump, 14 ... sensor for detecting impedance of developer, 15 ... impedance controller, 16 ... water, 17 ... replenisher for developer, 23 ... air-shielding plate, A ... developing zone, B ... rinsing zone, 110 ... developing zone, 111, 111', 112, 112', 121, 121', 126, 126' ... conveyer roller, 116 ... brush, 117, 118 ... spray, 120 ... rinsing or desensitizing zone.

## DETAILED EXPLANATION OF THE INVENTION

The present invention will hereunder be described in more detail.

In the method of the present invention as defined in claim 1, PS plates are processed comprising, as a substrate, an aluminum plate having an anodized layer of 0.5 to 6.0 $g/m^2$ and hence improved resistance to defects. Moreover, the method of this invention can be applied to the development processing performed at a high temperature ranging from 28 to 40° C with extremely excellent effects.

An example of the automatic developing machine for developing PS plates used in the present invention is shown in Fig. 1 More specifically, the apparatus is equipped with a storage tank for developer and a PS plate to be processed is conveyed and dipped in a developer 11 contained in the storage tank. A plate 23 for preventing the contact between the developer and air is disposed at an upper portion of the storage tank. Therefore, the alkaline developer used in the invention, in particular, developers composed of aqueous solutions having a high pH of not less than 12 is not deteriorated so severe that the foregoing problems arise since the absorption of carbon dioxide is effectively prevented by the plate 23, when compared with spraying type automatic developing machines as shown in Fig. 2 which have generally been used conventionally. This in turn results in the reduction of the amount of a replenisher to be supplemented. Moreover, the problem of contamination of the automatic developing machine can be solved since scattering of the developer due to spraying can also be prevented effectively.

If temperature is raised up to 28 to 40 ° C to perform a rapid development of the order of 5 to 18 seconds, the rate of evaporation of water is also increased and thus the developing properties of the developer correspondingly becomes unstable because of the concentration of the developer. For this reason, a plate for preventing the contact between the developer and air, i.e., a shielding plate is employed in the invention. The rate of shielding of the developer surface by the plate is of primary importance and thus is not less than 60% of the whole developer-air interface.

In the present invention, the composition of the developer used is also very important. More specifically, in a dipping-conveying type automatic developing machine used in the invention, a highly alkaline developer having a pH of not less than 12 is supplied to the surface of a PS plate in a large amount during development processing and, therefore, an aluminum substrate of the PS plate is liable to be etched. In particular, in the case of the PS plate whose aluminum substrate has an anodized film to enhance resistance to defects, a large amount of aluminum ions are dissolved out from the substrate into the developer. In particular, when the development processing is performed at a high temperature of the order of 28 to 40° C, this tendency is promoted and moreover, the concentration of aluminum ion in the developer is further increased because of the presence of an air-shielding plate which leads to the reduction in the amount of the replenisher. If the aluminum concentration in the developer is thus increased, silicates which are principal components of the developer undergo reaction with aluminum ions to form insoluble matters, which in turn causes the formation of precipitates in the developer. The precipitates possibly adhere to the PS plates during processing and in turn cause various troubles observed during printing operations or the precipitates are deposited on the bottom of the developing

EP 0 347 245 B1

tank as sludge. Therefore, troublesome washing operations are required.

Therefore, to perform development processing stably for a long time period utilizing a conveying type automatic developing machine comprising a dip-developing portion provided with a plate for preventing the contact between the developer and air as in the invention, particularly important are qualities such as strength of alkali and the concentration of silicates in the developer and, in particular, those of the replenisher for developer. Under such circumstances, the present inventors have found that the amount of aluminum ions dissolved out is low, that almost no insoluble matters are formed, that a rapid high temperature processing can be performed, that the amount of the replenisher to be supplemented is low and that a stable development processing can be performed over a long time period of the order of not less than 3 months without exchanging the developer only when the replenisher for developer having the foregoing composition is used.

The developers and the replenishers for developer used in the invention are aqueous solutions mainly composed of alkali metal silicates and alkali metal hydroxides. As such alkali metal silicates, preferably used are, for instance, sodium silicate, potassium silicate, lithium silicate and sodium metasilicate. On the other hand. as such alkali metal hydroxides, preferred are sodium hydroxide, potassium hydroxide and lithium hydroxide. From the viewpoint of preventing the formation of insoluble precipitates, it is particularly desirable that the developer comprise at least 20 mole% of potassium with respect to the total amount of alkali metals in the aqueous developing solution.

The developers and the replenishers used in the invention may simultaneously contain other alkaline agents. Examples of such other alkaline agents include such inorganic alkaline agents as ammonium hydroxide, sodium tertiary phosphate, sodium secondary phosphate, potassium tertiary phosphate, potassium secondary phosphate, ammonium tertiary phosphate, ammonium secondary phosphate, sodium bicarbonate, sodium carbonate, potassium carbonate and ammonium carbonate; and such organic alkaline agents as mono-, di- or triethanolamine, mono-, di- or trimethylamine, mono-, di- or triethylamine, mono- or di- isopropylamine, n-butylamine, mono-, di- or triisopropanolamine, ethyleneimine, ethylenediimine and tetramethylammonium hydroxide.

In the present invention, particularly important is the molar ratio of silicate $[SiO_2]$ to alkali metal oxide $[M_2O]$ in the replenisher for developer and the molar ratio, $[SiO_2] / [M_2O]$ is generally 0.6 to 1.5, preferably 0.7 to 1.3. This is because if the molar ratio is less than 0.6, an automatic developing machine used is severely contaminated and great scattering of activity thereof is also observed, while if it exceeds 1.5, it becomes difficult to perform rapid development and the dissolving out or removal of the light-sensitive layer on non-image areas is liable to be incomplete. In addition, the concentration of $SiO_2$ in the replenisher preferably ranges from 2 to 4% by weight. Such limitation of the concentration of $SiO_2$ makes it possible to stably provide lithographic printing plates having good finishing qualities without causing formation of feculences even when a large amount of PS plates are processed for a long time period.

In a particularly preferred embodiment of this invention, an aqueous solution of an alkali metal silicate having a molar ratio, $[SiO_2] / [M_2O]$, which ranges from 1.0 to 1.5 and a concentration of $SiO_2$ of 1 to 4% by weight is used as a developer. In such a case, it is a matter of course that a replenisher having alkali strength equal to or more than that of the developer is employed. In order to decrease the amount of the replenisher to be supplied, it is advantageous that a molar ratio, $[SiO_2] / [M_2O]$, of the replenisher is equal to or smaller than that of the developer, or that a concentration of $SiO_2$ is high if the molar ratio of the developer is equal to that of the replenisher.

In the developers and the replenishers used in the invention, it is possible to simultaneously use organic solvents having solubility in water at 20° C of not more than 10% by weight according to need. Examples of such organic solvents are such carboxilic acid esters as ethyl acetate, propyl acetate, butyl acetate, amyl acetate, benzyl acetate, ethylene glycol monobutyl acatate, butyl lactate and butyl levulinate; such ketones as ethyl butyl ketone, methyl isobutyl ketone and cyclohexanone; such alcohols as ethylene glycol monobutyl ether, ethylene glycol benzyl ether, ethylene glycol monophenyl ether, benzyl alcohol, methylphenylcarbinol, n-amyl alcohol and methylamyl alcohol; such alkyl-substituted aromatic hydrocarbons as xylene; and such halogenated hydrocarbons as methylene dichloride and monochlorobenzene. These organic solvents may be used alone or in combination. Particularly preferred is benzyl alcohol in the invention. These organic solvents are added to the developer or replenisher therefor generally in an amount of not more than 5% by weight and preferably not more than 4% by weight.

The developers and replenishers used in the present invention may simultaneously contain a surfactant for the purpose of improving developing properties thereof. Examples of such surfactants include salts of higher alcohol $(C_8 \sim C_{22})$ sulfuric acid esters such as sodium salt of lauryl alcohol sulfate, sodium salt of octyl alcohol sulfate, ammonium salt of lauryl alcohol sulfate, Teepol B-81 (trade mark; available from Shell Chemicals Co., Ltd.) and disodium alkyl sulfates; salts of aliphatic alcohol phosphoric acid esters such as sodium salt of cetyl alcohol phosphate; alkyl aryl sulfonic acid salts such as sodium salt of dodecylbenzene sulfonate, sodium salt

4

of isopropylnaphthalene sulfonate, sodium salt of dinaphthalene disulfonate and sodium salt of metanitrobenzene sulfonate; sulfonic acid salts of alkylamides such as $C_{17}H_{33}$ $CON(CH_3)CH_2CH_2SO_3Na$; and sulfonic acid salts of dibasic aliphatic acid esters such as sodium dioctyl sulfosuccinate and sodium dihexyl sulfosuccinate. These surfactants may be used alone or in combination. Particularly preferred are sulfonic acid salts. These surfactants may be used in an amount of generally not more than 5% by weight and preferably not more than 3% by weight.

In order to enhance developing stability of the developers and replenishers used in the invention, the following compounds may simultaneously be used.

Examples of such compounds are neutral salts such as $NaC\ell$, $KC\ell$ and KBr as disclosed in J.P. KOKAI No. Sho 58-75152; chelating agents such as EDTA and NTA as disclosed in J.P. KOKAI No. Sho 58-190952 (U.S. Patent 4,469,776); complexes such as $[Co(NH_3)_6]$ $C\ell_3$ as disclosed in J.P. KOKAI No. Sho 59-121336 (U.S. Patent 4,606,995); ionizable compounds of elements of the group IIa, IIIa or IIIb the of Periodic Table such as those disclosed in J.P. KOKAI No. Sho 55-25100; anionic or amphoteric surfactants such as sodium alkyl naphthalene sulfonate and N-tetradecyl-N,N-dihydroxyethyl betaine as disclosed in J.P. KOKAI No. Sho 50-51324; tetramethyldecyne diol as disclosed in U.S. Patent No. 4,374,920; nonionic surfactants as disclosed in J.P. KOKAI No. Sho 60-213943; cationic polymers such as methyl chloride quaternary products of p-dimethylaminomethyl polystyrene as disclosed in J.P. KOKAI No. Sho 55-95946; amphoteric polyelectrolytes such as copolymer of vinylbenzyl trimethylammonium chloride and sodium acrylate as disclosed in J.P. KOKAI No. Sho 56-142528; reducing inorganic salts such as sodium sulfite as disclosed in J.P. KOKAI No. Sho 57-192952 (U.S. Patent 4,467,027) and alkaline-soluble mercapto compounds or thioether compounds such as thiosalicylic acid, cysteine and thioglycolic acid; inorganic lithium compounds such as lithium chloride as disclosed in J.P. KOKAI No. Sho 58-59444; organic lithium compounds such as lithium benzoate as disclosed in Japanese Patent Publication for Opposition Purpose (hereinafter referred to as "J.P. KOKOKU") No. Sho 50-34442; organometallic surfactants containing Si, Ti or the like as disclosed in J.P. KOKAI No. Sho 59-75255; organoboron compounds as disclosed in J.P. KOKAI No. Sho 59-84241 (U.S. Patent 4,500,625); quaternary ammonium salts such as tetraalkylammonium oxides as disclosed in European Patent No. 101,010; and bactericides such as sodium dehydroacetate as disclosed in Japanese Patent Application Serial (hereinafter referred to as "J.P.A.") No. Sho 61-298534 (J.P. KOKAI No. Sho 63-226657).

In the method for development processing of the present invention, any known means of supplementing a replenisher for developer may be employed. Examples of such methods preferably used are a method for intermittently or continuously supplementing a replenisher as a function of the amount of PS plates processed and time as disclosed in J.P. KOKAI No. Sho 55-115039 (G.B. 2046931A), a method comprising disposing a sensor for detecting the degree of the light-sensitive layer dissolved out in the middle portion of a developing zone and supplementing the replenisher in proportion to the detected degree of the light-sensitive layer dissolved out as disclosed in J.P. KOKAI No. Sho 58-95349 (U.S. Patent 4,537,496); a method comprising determining the impedance value of a developer and processing the detected impedance value by a computer to perform supplementation of a replenisher as disclosed in G.B. 2208249A.

The PS plates processed according to the method of this invention are comprised of a substrate having hydrophilic surfaces provided thereon with a light-sensitive layer containing a light-sensitive composition. Examples of such light-sensitive compositions used herein are those comprising diazo compounds; those comprising azide compounds as disclosed in U.K. Patent Nos. 1,235,281 and 1,495,861; those containing photocross-linkable photopolymers as disclosed in U.S. Patent No. 3,860,426; those containing photopolymerizable photopolymers as disclosed in U.S. Patent Nos. 4,072,528 and 4,072,527; photoconductive compositions as disclosed in J.P. KOKAI Nos. Sho 56-19063 and 56-29250; and silver halide emulsion compositions as disclosed in J.P. KOKAI Nos. Sho 52-62501 and 56-111852.

Among these light-sensitive compositions, preferably used are those comprising diazo compounds since they are synthetically excellent in various properties such as storage properties of the light-sensitive layer; developability, for instance, development latitude; image properties, e.g. quality of images; printing properties, e.g., ink receptivity and wear resistance; and low possibility of causing environmental pollution of developers used.

The light-sensitive compositions containing diazo compounds can roughly be divided into two groups, i.e., negative-working type and positive-working type ones.

The negative-working light-sensitive compositions containing diazo compounds comprise light-sensitive diazo compounds and preferably polymeric compounds. As the light-sensitive diazo compounds there may be used any ones conventionally known and preferred examples thereof are salts of organic solvent-soluble diazo resins such as salts of condensates of p-diazodiphenylamine and formaldehyde or acetaldehyde with hexafluorophosphates and salts thereof with 2-hydroxy-4-methoxybenzophenone-5-sulfonic acid salts.

On the other hand, examples of the foregoing polymeric compounds preferably used are copolymers of

EP 0 347 245 B1

acrylic acid or methacrylic acid; crotonic acid copolymers, itaconic acid copolymers, maleic acid copolymers, cellulose derivatives having carboxyl groups on the side chains thereof, polyvinyl alcohol derivatives having carboxyl groups on the side chains thereof, copolymers of hydroxyalkyl (meth)acrylate having carboxyl groups on the side chains thereof, and unsaturated polyester resins having carboxyl groups.

As the diazo compounds used in the positive-working light-sensitive composition, any compounds conventionally known may be utilized and typical examples thereof are o-quinonediazides and preferably o-naphthoquinonediazide compounds. Particularly preferred are o-naphthoquinonediazidosulfonic acid esters or o-naphthoquinone diazidocarboxylic acid esters of various hydroxyl compounds; and o-naphthoquinonediazidosulfonic acid amides or o-naphthoquinonediazidocarboxylic acid amides of various aromatic amine compounds. Preferred hydroxyl compounds are condensed resins of phenols and carbonyl group-containing compounds. Examples of such phenols include phenol, cresol, resorcin and pyrogallol; examples of such carbonyl group-containing compounds are formaldehyde, benzaldehyde and acetone. Examples of preferred hydroxyl compounds include phenol-formaldehyde resin, cresol-formaldehyde resin, pyrogallol-acetone resin and resorcin-benzaldehyde resin.

Typical examples of o-quinonediazide compounds include esters of benzoquinone-(1,2)-diazidosulfonic acid or naphthoquinone-(1,2)-diazidosulfonic acid and phenol-formaldehyde resin or cresol-formaldehyde resin; ester of naphthoquinone-(1,2)-diazido-(2)-5-sulfonic acid and resorcin-benzaldehyde resin as disclosed in J.P. KOKAI No. Sho 56-1044; ester of naphthoquinone-(1,2)-diazidosulfonic acid and pyrogallol-acetone resin as disclosed in U.S. Patent No. 3,635,709; and ester of naphthoquinone-(1,2)-diazido-(2)-5-sulfonic acid and resorcin-pyrogallol-acetone copolycondensates as disclosed in J.P. KOKAI No. Sho 55-76346.

Examples of other useful o-quinonediazide compounds are polyesters having hydroxyl groups at their termini esterified with o-naphthoquinonediazidosulfonyl chloride as disclosed in J.P. KOKAI No. Sho 50-117503; homopolymers of p-hydroxystyrene or copolymers thereof with other copolymerizable monomers esterified with o-naphthoquinonediazidosulfonyl chloride as disclosed in J.P. KOKAI No. Sho 50-113305; ester of bisphenol-formaldehyde resin and o-quinonediazidosulfonic acid as disclosed in J.P. KOKAI No. Sho 54-29922; condensates of alkyl acrylate-acryloyloxyalkyl carbonate-hydroxyalkyl acrylate copolymers with o-naphthoquinonediazidosulfonyl chloride as disclosed in U.S. Patent No. 3,859,099; reaction products of copolymerized products of styrene and phenol derivatives with o-quinonediazidosulfonic acid as disclosed in J.P. KOKOKU No. Sho 49-17481; amides of copolymers of p-aminostyrene and monomers copolymerizable therewith and o-naphthoquinonediazidosulfonic acid or o-naphthoquinonediazidocarboxylic aicd as disclosed in U.S. Patent No. 3,759,711; as well as ester compounds of polyhydroxybenzophenone and o-naphthoquinonediazidosulfonyl chloride.

These o-quinonediazide compounds may be used alone, but are preferably used as a mixture with an alkali-soluble resin to form a light-sensitive layer.

Preferred alkali-soluble resins include novolak type phenol resins and typical examples thereof are phenol-formaldehyde resin, cresol-formaldehyde resin, and phenol-cresol-formaldehyde copolycondensed resins as disclosed in J.P. KOKAI No. Sho 55-57841. More preferably, the foregoing phenol resins are simultaneously used with a condensate of phenol or cresol substituted with an alkyl group having 3 to 8 carbon atoms and formaldehyde such as t-butylphenol-formaldehyde, as described in J.P. KOKAI No. Sho 50-125806.

Moreover, it is also possible to optionally incorporate, into the light-sensitive composition, alkali-soluble polymers other than the above listed alkali-soluble novolak phenolic resins. Examples of such polymers are styrene-acrylic acid copolymer, methyl methacrylate-methacrylic acid copolymer, alkali-soluble polyurethane resin, and alkali-soluble vinylic resins and alkali-soluble polybutyral resins as disclosed in J.P. KOKOKU No. Sho 52-28401.

The amount of the o-quinonediazide compounds is preferably 5 to 80% by weight and more preferably 10 to 50% by weight based on the total weight of the solid contents of the light-sensitive composition. On the other hand, that of the alkali-soluble resins is preferably 30 to 90% by weight and more preferably 50 to 85% by weight based on the total weight of the solid contents of the light-sensitive composition.

The layer of the light-sensitive composition may be applied in the form of a multilayered structure. Moreover, the light-sensitive composition may further comprise optional components such as dyes, plasticizers and components for imparting printing-out properties (ability of providing a visible image immediately after imagewise exposure).

The coated amount of the light-sensitive composition applied onto the surface of a substrate preferably ranges from 0.1 to 7 g/m$^2$ and more preferably 0.5 to 4 g/m$^2$.

It is also optionally possible to dispose an underlying coating between the substrate and the light-sensitive layer, for instance, those composed of a metal salt and hydrophilic cellulose as disclosed in J.P. KOKOKU No. Sho 57-16349; a polyvinylsulfonic acid layer as disclosed in J.P. KOKOKU No. Sho 46-35685; a layer of $\beta$-alanine as disclosed in J.P. KOKAI No. Sho 60-149491; or a layer of triethanolamine hydrochloride as disclosed

6

in J.P. KOKAI No. Sho 60-232998.

As substrates used in the PS plates processed by the method of this invention, preferred are aluminum (inclusive of aluminum alloys) plates, paper, plastic films such as polyethylene, polypropylene, polyethylene terephthalate, cellulose diacetate, cellulose triacetate. cellulose propionate, polyvinyl acetal and polycarbonate plates, and composite substrates composed of metal plates such as copper and zinc plates which are laminated with an aluminum foil or on which aluminum layer is deposited.

The surface of these substrate is generally subjected to surface roughening treatment for the purpose of enhancing the water-retention property and improving the adhesion between the surface and the light-sensitive layer. As such surface roughening treatments there may be mentioned such commonly known methods as brush graining, ball graining, electrolytic etching, chemical etching, liquid honing, sand blast and a combination thereof, preferably brush graining, electrolytic etching, chemical etching and liquid honing and, in particular, the surface roughening treatments which include electrolytic etching process. Electrolytic baths used in the electrolytic etching are aqueous solutions containing acids, alkalis or salts thereof, or those containing organic solvents. Particularly preferred are electrolytes containing hydrochloric acid, nitric acid or a salt thereof.

Furthermore, the aluminum plate which has been surface-roughened is optionally desmutted with an aqueous solution of an acid or an alkali. The aluminum plate thus obtained is preferably anodized. Particularly preferred method for anodization is to subject it to such treatment in a bath containing sulfuric acid or phosphoric acid. Moreover, the aluminum plate may be subjected to other surface treatments such as sealing treatment and dipping in an aqueous solution of potassium fluorozirconate.

The method of this invention is particularly effective for processing PS plates whose substrate is anodized to enhance its resistance to scratching and it is a real surprise that the method of this invention makes it possible to process PS plates provided thereon with an anodized layer of 0.5 to 6.0 $g/m^2$, from which aluminum ions are easily delivered in a rapid processing, continuously over several months without exchanging the developer.

The PS plates thus obtained are imagewise exposed, through an original transparency, to light from a light source rich in actinic rays such as a carbon arc lamp, a mercury lamp, a metal halide lamp, a tungsten lamp and a xenon lamp and are subsequently developed.

In the method of this invention, PS plates developed are optionally subjected to water washing processes (with running water or circulating water washing), processes for rinsing the plates with an aqueous solution containing a surfactant, a desensitization treatment as well as a combination of water washing and rinsing processes or rinsing and desensitization treatments.

The present invention will hereunder be explained in more detail with reference to the following non-limitative working Examples and the effects practically achieved by the present invention will also be discussed in detail in comparison with Comparative Examples.

Example 1

An aluminum plate (1S) which had been grained was immersed in 2 wt% aqueous solution of sodium hydroxide maintained at 40 ° C for one minute to etch the plate. Then the plate was washed and was dipped in a sulfuric acid-chromic acid mixture for about one minute to expose the pure aluminum surface. The plate was immersed in 20 wt% sulfuric acid solution maintained at 30 ° C, was anodized at a DC voltage of 15V and a current density of 2 $A/dm^2$ for 3 minutes to form an anodized layer of 3.0 $g/m^2$, washed with water and dried. A PS plate was prepared by applying a solution of the following light-sensitive composition on the surface of the aluminum plate thus treated so that the amount of the solution applied was 2 $g/m^2$ (weighed after drying) and then drying.

| Component | Amount (g) |
|---|---|
| Naphthoquinone-1,2-diazido-(2)-5-sulfonic acid ester of acetone-pyrogallol resin (synthesized by a method disclosed in Example 1 of U.S. Patent No. 3,635,709) | 5 |
| t-Butylphenol-formaldehyde resin (PR-50530; available from SUMITOMO DUREZ CO., LTD.) | 0.5 |
| Cresol-formaldehyde resin (HITANOL #3110; available from Hitachi Chemical Co., Ltd.) | 5 |
| Methyl ethyl ketone | 50 |
| Cyclohexanone | 40 |

The positive-working PS plate thus obtained was imagewise exposed, through an original transparency, to light from a 3 KW metal halide lamp for 60 seconds.

Then the imagewise exposed PS plate was developed using a dip-conveying type automatic developing machine shown in Fig. 1 and a developer and a replenisher therefor detailed below.

(1) Automatic Developing Machine

The machine comprises a developing bath A for storing the developer and dipping the PS plates. to be processed and a bath B for rinsing and processes the exposed PS plates successively while conveying the plates. The machine further comprises devices (10, 21) for circulating each processing solution in the order of a storage tank --> a pump --> a spray --> the storage tank and devices (12 to 17) for supplemeting each replenisher to the corresponding processing bath. Each processing bath is designed so that excess of each processing solution is delivered by overflow. As a plate for shielding air of the developing bath there is used such a plate having rate of shielding of 70%.

(2) 20ℓ of a developer A having the following composition was charged into the foregoing developing bath.

| Component | Amount (part by weight) |
|---|---|
| JIS No. 3 sodium silicate (40 wt% aqueous solution) | 50 |
| Potassium hydroxide (40 wt% aqueous solution) | 30 |
| Pure water | 1000 |

$[SiO_2] / [M_2O] = 1.20$; $[SiO_2] = 1.39$ wt%.

(3) Replenisher for Developer

A replenisher B for developer having the following composition (500 m ℓ each) was supplemented every change in solid portion of an Exposing Step Tablet for PS plates (available from Fuji Photo Film Co., Ltd.) by 1/2 corresponding to the amount of the PS plates processed. In addition, the replenisher was supplemented in the morning after stopping the automatic developing machine at night and during holidays in an amount corresponding to the change in step tablet to regenerate the developer. The development processing was thus continued.

Replenisher B for Developer

```
Component                                          Amount (part by weight)

JIS No. 3 sodium silicate (40 wt% aqueous solution)    150

Potassium hydroxide (40 wt% aqueous solution)           90

Pure water                                            1000

   [SiO₂] / [M₂O] = 1.20;  [SiO₂] = 3.63 wt%.
```

$$[SiO_2] / [M_2O] = 1.20; \quad [SiO_2] = 3.63 \text{ wt}\%.$$

### (4) Post Treatments

A commercialy available rinse solution FR-2 (available from Fuji Photo Film Co., Ltd.) was diluted in a ratio of 1:7 with water and 8 $\ell$ of the diluted rinse solution was charged into a bath for rinsing. A diluted (1:15) rinsing solution FR-2 was supplemented thereto in an amount of 40 m$\ell$ per 1 m² of the processed PS plate.

A rapid development processing of PS plates in which temperature of the developer was 30° C and time for development processing was 10 seconds was performed under the foregoing conditions. PS plates having a size of 1003 mm X 800 mm were processed in a rate of 60 sheets per day for 3 months. Although PS plates provided thereon with an anodized layer of 3.0 g/m² were subjected to high temperature rapid processing, there was not observed any adhesion of contaminants on the PS plate processed and almost no precipitates were deposited on the bottom of the developing bath. This clearly indicates that very stable development processing could be performed. In addition, the amount of the replenisher supplemeted (including those supplemented during operation and those for regenerating the deterioration of the developer during stopping the machine at night and during holidays) was only 70 m$\ell$ per 1 m² of the processed PS plate.

### Comparative Example 1

Using a conventional spraying type automatic developing machine as shown in Fig. 2 and the same PS plates, developer and replenisher as those used in Example 1, a rapid development processing in which temperature of the developer was 30° C and time for development processing was 10 seconds was performed as in Example 1. Two weeks after the initiation of the processing, there was formed sludge-like precipitates on the bottom of a developing bath and three weeks thereafter, contaminants were adhered to the surface of the processed PS plate. Moreover, the amount of the replenisher to be supplemented was 125 m$\ell$ per 1 m² of the processed PS plate.

### Comparative Example 2

Using the same automatic developing machine, developer and replenisher as those used in Comparative Example 1, a development processing was performed at a temperature of 25° C and, as a result, it took 20 seconds for the development processing. This indicates that rapid processing could not be performed in this Comparative Example.

### Examples 2 to 5 and Comparative Examples 3 to 4

Utilizing the same automatic developing machine and the developer A as those used in Example 1, the same development processing was carried out while variously changing a molar ratio [SiO₂] / [M₂O]. The replenishers C to I were prepared by changing the amounts of No. 3 sodium silicate, potassium hydroxide and water. The results obtained are listed in Table I below.

Table I

| Ex. No. | Replenisher for Developer | | | Stability of Development |
| --- | --- | --- | --- | --- |
| | No. | Molar ratio $SiO_2/M_2O$ | Content of $SiO_2$ (wt%) | |
| 3 * | C | 0.40 | 3.63 | Great scattering of sensitivity Minimum dot are easily lost |
| 2 | D | 0.60 | 3.63 | Slightly great scattering of sensitivity |
| 3 | E | 0.80 | 3.63 | Good |
| 4 | F | 1.00 | 3.63 | Good |
| 1 | G | 1.20 | 3.63 | Good |
| 5 | H | 1.50 | 3.63 | Good |
| 4 * | I | 1.70 | 3.63 | Lot of remaining color on non-image area; contamination around portions to be removed. |

*: Comparative Example.

"around portions to be removed" means the periphery of un-necessary images to be removed.

Table I (continued)

| Ex. No. | Required Developing Time (sec) | Contamination of Automatic Developing Machine | Average Amount of Replenisher m ℓ (per 1m²) |
| --- | --- | --- | --- |
| 3 * | 10 | After 2 weeks, sludge is formed | 30 |

EP 0 347 245 B1

in developing bath; white conta-

minants  on roller

| | | | |
|---|---|---|---|
| 2 | 10 | good for 2 months | 40 |
| 3 | 10 | good for more than 3 months | 50 |
| 4 | 10 | ditto | 60 |
| 1 | 10 | ditto | 70 |
| 5 | 20 | ditto | 85 |
| 4 · | 30 | ditto | 120 |

"White contaminants on roller" means that the roller is contaminated with white substances mainly composed of silicates used.

When the replenisher C (molar ratio 0.4) was used, the amount of the replenisher was low, but the contamination of the automatic developing machine was severe and the scattering of sensitivity was great. In addition, when the replenisher I (molar ratio 1.70) was used, a rapid processing of the order of not more than 20 seconds could not be performed, the properties of development of non-image areas, hence the remaining color was great, the contamination around the portions to be removed was severe and the amount of the replenisher was also great. It is found that when the molar ratio was less than 0.6, insoluble sludge was liable to be formed on the bottom of the developing bath and the sensitivity was also liable to cause scattering and that when the molar ratio was more than 1.5, the development became insufficient and the stability of the processing was low. Therefore, it can be concluded that the molar ratio, $[SiO_2] / [M_2O]$ , should be preferably limited to the range of from 0.6 to 1. and more preferably 0.7 to 1.3. Moreover, when the molar ratio was 1.2 and the content of $SiO_2$ was less than 2 % by weight, the amount of the replenisher to be supplemented was increased and the lowering of the sensitivity was also great, while when the content of $SiO_2$ exceeded 4% by weight, sludge was formed in the developing bath and a long term processing could not be performed.

Although a developer mainly composed of a silicate is used in the method of the present invention, the method makes it possible to stably and rapidly continue the development processing for a long time period, the contamination of the automatic developing machine is very low and washing operations can be easily performed. Moreover, there are not observed adhesion of feculences onto the surface of PS plates and formation of scratch thereon during the processing. In addition, the method also makes it possible to reduce the amount of the replenisher to be used. Thus lithographic printing plates having constant quality can be obtained and the running cost can be greatly reduced.

## Claims

1. A method for development processing a presensitised plate for use in making a lithographic printing plate comprising the steps of:
   (i) imagewise exposing to light a presensitised plate comprising an aluminum plate having an anodised layer of 0.5 to 6 g/m$^2$ and a lithographically suitable photosensitive layer on the anodised layer; and
   (ii) development processing the exposed presensitised plate utilising a conveying type automatic developing machine while conveying and dipping the plate in an alkaline developer charged in a tank, and while appropriately supplying a replenisher to the tank, the machine being provided with a plate for reducing contact between air and a surface of the alkaline developer in the tank so as to remove non-image areas of the photosensitive layer and the plate providing a rate of shielding of the developer surface for preventing the contact between the developer and air which is not less than 60% of the whole developer-air interface; wherein the developer and the replenisher are aqueous solutions of an alkali metal silicate, and wherein the ratio $[SiO_2]/[M_2O]$ of the replenisher ranges from 0.6 to 1.5, wherein $[SiO_2]$ is the molar concentration of $SiO_2$ and $[M_2O]$ is the molar concentration of an alkali metal oxide $M_2O$.

11

2. A method according to Claim 1, wherein the ratio, $[SiO_2]/[M_2O]$, of the replenisher ranges from 0.7 to 1.3.

3. A method according to Claim 1 or 2, wherein the content of $SiO_2$, in the replenisher ranges from 2 to 4% by weight.

4. A method according to Claim 1, 2 or 3, wherein the alkali metal silicate is at least one of sodium silicate, potassium silicate and lithium silicate.

5. A method according to Claim 4, wherein the content of potassium in the developer is not less than 20 mole % on the basis of the total alkali metals present in the aqueous developer solution.

6. A method according to any one of Claims 1 to 5, wherein the presensitised plate is comprised of an aluminium plate having an anodised layer of 0.5 to 6 $g/m^2$.

7. A method according to any one of Claims 1 to 6, wherein the presensitised plate comprises an anodised aluminium support having provided thereon a photosensitive layer comprising an o-naphthoquinonediazide compound and an alkali-soluble resin.

8. A method according to Claim 7, wherein the alkali-soluble resin is a novolak phenolic resin.

9. A method according to any one of Claims 1 to 8, wherein the development is performed at a temperature ranging from 28 to 40°C.

10. A method according to any one of Claims 1 to 9, wherein the development processing is performed for 5 to 18 seconds.

**Patentansprüche**

1. Verfahren zur Entwicklungsverarbeitung einer vorsensibilisierten Platte zur Verwendung bei der Herstellung einer lithographischen Druckplatte umfassend die Schritte

   (i) bildmäßiges Belichten einer vorsensibilisierten Platte umfassend eine Aluminiumplatte mit einer anodisierten Schicht von 0,5 bis 6 g / $m^2$ und einer lithographisch geeigneten lichtempfindlichen Schicht auf der anodisierten Schicht; und

   (ii) Entwicklungsverarbeitung der belichteten vorsensibilisierten Platte unter Verwendung einer automatischen Entwicklungsmaschine vom Transportier-Typ, wobei die Platte in einen in einem Tank befindlichen alkalischen Entwickler befördert und eingetaucht wird, und wobei eine Nachfüll-Lösung dem Tank angemessen zugeführt wird, wobei die Maschine mit einer Platte zur Kontaktverminderung zwischen Luft und einer Oberfläche des alkalischen Entwicklers im Tank versehen ist, um die Nichtbildbereiche der lichtempfindlichen Schicht zu entfernen, und wobei die Platte zur Vermeidung des Kontaktes zwischen dem Entwickler und der Luft eine Abschirmung der Entwickleroberfläche bewirkt, welche nicht geringer ist als 60% der gesamten Entwickler-Luft Grenzfläche; worin der Entwickler und die Nachfüll-Lösung wäßrige Lösungen eines Alkalimetallsilikates sind, und wobei das Verhältnis $[SiO_2]/[M_2O]$ der Nachfüll-Lösung von 0,6 bis 1,5 reicht, wobei $[SiO_2]$ die molare Konzentration von $SiO_2$ und $[M_2O]$ die molare Konzentration eines Alkalimetalloxids $M_2O$ ist.

2. Verfahren gemäß Anspruch 1, worin das Verhältnis $[SiO_2]$ / $[M_2O]$ der Nachfüll-Lösung von 0,7 bis 1,3 reicht.

3. Verfahren gemäß Anspruch 1 oder 2, worin der Gehalt des $SiO_2$ in der Nachfüll-Lösung von 2 bis 4 Gewichts-% reicht.

4. Verfahren gemäß Anspruch 1, 2 oder 3, bei dem das Alkalimetallsilikat mindestens eines, gewählt aus Natriumsilikat, Kaliumsilikat oder Lithiumsilikat, ist.

5. Verfahren gemäß Anspruch 4, bei dem der Gehalt des Kaliums im Entwickler nicht weniger als 20 Mol % auf der Basis der gesamten in der wäßrigen Entwicklerlösung anwesenden Alkalimetalle ist.

6. Verfahren gemäß einem der Ansprüche 1 - 5, bei dem die vorsensibilisierte Platte eine Aluminiumplatte mit einer anodisierten Schicht von 0,5 bis 6 g / $m^2$ umfaßt.

7. Verfahren gemäß einem der Ansprüche 1 - 6, bei dem die vorsensibilisierte Platte einen anodisierten Aluminiumträger mit einer darauf aufgebrachten lichtempfindlichen Schicht, umfassend eine o-Naphtochinondiazidverbindung und ein alkalilösliches Harz, umfaßt.

8. Verfahren gemäß Anspruch 7, bei dem das alkalilösliche Harz ein Novolack-Phenolharz ist.

9. Verfahren gemäß einem der Ansprüche 1 - 8, bei dem die Entwicklung bei einer von 28 ° C bis 40 ° C reichenden Temperatur ausgeführt wird.

10. Verfahren gemäß einem der Ansprüche 1 - 9, bei dem die Entwicklungverarbeitung in 5 bis 18 Sekunden ausgeführt wird.

## Revendications

1. Méthode de traitement de développement de plaque présensibilisée pour la préparation d'un cliché d'imprimerie lithographique comportant les phases suivantes:

   (i) exposition en image à la lumière d'une plaque présensibilisée comportant une plaque d'aluminium ayant une couche anodisée de 0,5 à 6 $g/m^2$ et une couche photosensible prévue pour la lithographie sur la couche anodisée; et

   (ii) traitement en développement de la plaque présensibilisée exposée exploitant une machine automatique de développement du modèle à convoyeur lors du transport et de l'immersion de la plaque dans un bain de produit alcalin de développement mis dans un réservoir, et lors de l'apport d'un appoint au réservoir, la machine comportant un capot pour réduire le contact de l'atmosphère avec la surface du bain alcalin de développement dans le réservoir de telle façon à éliminer les zones non-image de la couche photosensible et la plaque permettant un taux de protection de la surface du révélateur pour éviter le contact entre le révélateur et l'atmosphère à raison d'un minimum de 60% de l'interface entière du révélateur et de l'atmosphère, suivant lequel le révélateur et l'appoint sont des solutions aqueuses de silicate métallique alcalin, et suivant lequel le rapport [$SiO_2$] [$M_2O$] de la fourchette de révélateurs entre 0,6 et 1,5 dont [$SiO_2$] est la concentration molaire de $SiO_2$, et [$M_2O$] est la concentration molaire d'un oxyde métallique alcalin $M_2O$.

2. Méthode selon la revendication 1, suivant laquelle le rapport [$SiO_2$] [$M_2O$] du produit d'appoint varie entre 0,7 et 1,3.

3. Méthode selon la revendication 1 ou 2, suivant laquelle la teneur en $SiO_2$ du réservoir de produit d'appoint varie entre 2 et 4% par poids.

4. Méthode selon la revendication 1, 2 ou 3, suivant laquelle le silicate métallique alcalin est au minimum l'un des silicates de sodium, de potassium et de lithium.

5. Méthode selon la revendication 4, suivant laquelle la teneur en potassium du révélateur est au minimum 20 moles % sur la base de la teneur globale de métaux alcalins présents dans la solution aqueuse de révélateur.

6. Méthode selon l'une ou l'autre des revendications 1 à 5, suivant laquelle la plaque présensibilisée consiste d'une plaque d'aluminium portant une couche anodisée de 0,5 à 6 $g/m^2$.

7. Méthode selon l'une ou l'autre des revendications à 6, suivant laquelle la plaque présensibilisée comporte un support d'aluminium anodisé portant une couche photosensible prévoyant un composé o-naphthoquinonediazide et une résine soluble en milieu alcalin.

8. Méthode selon la revendication 7, suivant laquelle la résine soluble en milieu alcalin est une résine phénolique novolaque.

9. Méthode selon l'une ou l'autre des revendications 1 à 8, suivant laquelle le développement est exécuté à une température variant entre 28 et 40°C.

10. Méthode selon l'une ou l'autre des revendications 1 à 9, suivant laquelle le traitement en développement est effectué en 5 à 18 secondes.

# FIG.1

EP 0 347 245 B1

# FIG.2